# EUROPEAN PATENT APPLICATION

(11) **EP 0 562 569 A2**
(43) Date of publication of application: **29.09.1993**
(21) Application number: 93104821.9
(22) Date of filing: 24.03.1993
(51) Int. Cl.: H05K 3/32, H01L 21/60, H01R 4/04

(54) **Anisotropic adhesive for fixing an electronic component to a printed circuit module**

(30) Priority: 25.03.1992 DE 4209596
(71) Applicant: MOLEX INCORPORATED, Lisle Illinois 60532 (US)
(72) Inventor: Bientz, Alfred, F-53200 Chateau-Gontier (FR)
(74) Representative: Blumbach Weser Bergen Kramer Zwirner Hoffmann Patentanwälte

(57) **Abstract**

An anisotropic adhesive (10) for effecting an electrical connection between an electronic component (5) and a printed circuit module, in which the printed circuit module consists of a flexible or rigid substrate (1) having conductive structures printed thereon in the form of conductive traces (9) with contact areas (4). The contact areas (4) of the conductive traces (9) are electrically connected by the electronic component (5) which is fixed on the circuit module with the adhesive (10). The adhesive has electrically conductive particles distributed therethrough for effecting the connection. The particles comprise hard, non-oxidizing crystallites (8) consisting of an electrically-conductive crystalline compound of an element of sub-group IV of the Periodic Table, together with nitrogen or carbon. The crystallites are distributed within the adhesive such that there is little or no physical contact between them and therefore the adhesive is non-conductive in a direction along the layer plane. In addition, a process is disclosed wherein the crystallite-containing adhesive (10) is applied to the substrate (1) in a compact layer of such thickness that by pressing on the component the crystallites (8) are exposed to the contact surfaces (6) of the electronic component (5) and to the contact areas (4) of the traces (9) to effect an electrical connection therebetween.

## Description

### Field of the Invention:

The invention is directed to an anisotropic adhesive for effecting an electrical connection between an electronic component and a printed circuit module, in which the printed circuit module consists of a flexible or rigid substrate having conductive structures printed thereon in the form of conductive traces with contact areas. The contact areas of the conductive traces are connected by the electronic component which is fixed on the circuit module with the aid of the adhesive. The adhesive has electrically conductive particles distributed therethrough for effecting the connection.

### Background of the Invention:

In a typical printed circuit module, electrically conductive traces may consist of a printed ink layer having therein embedded metallic conductive particles, such as silver. Typically the silver particles are applied by a screen printing process. The amount of particles incorporated in the ink layer is adjusted so that the particles are in contact with one another, and it is through this contact that the traces become conductive. Often however, environmental factors affect the conductivity of the conductive particles, for example by corrosion, which severely affects the operating reliability of the printed circuit module. In order to prevent such conditions, it is known to apply protective cover films or coatings, such as carbon, over the conductive traces. This is both time consuming and costly however, since the coating or protective film on the contact areas must be removed again before making contact with complementary contact surfaces of an electronic component. In order to avoid such costly procedures, it is known to plate the contact areas of the conductive traces with a non-oxidizing metal such as gold. However, this solution may also be costly. Furthermore, the complementary contact surface of the electronic component must also be plated with the same or similar non-oxidizing metal and/or free from protective films and coatings in order to effect a satisfactory electrical connection. In either type of arrangement, the electronic component is usually fixed in place on the printed circuit module by an adhesive. Typically, the adhesive itself does not contribute directly to the electrical connection, and to that extent functions only as a mechanical aid for fixing the two contact surfaces in electrical engagement.

### Summary of the Invention:

The invention contemplates a process which alleviates the problems outlined above associated with making a reliable electrical connection between an electronic component and the conductive traces of a printed circuit module. The invention is directed to making such a connection in a very simple and low cost manner, while at the same time achieving a secure mechanical union between the component and the circuit module.

For solution of this task, the invention teaches that hard, non-oxidizing electrically-conductive crystallites are embedded in a known adhesive. The crystallites consist of an electrically-conductive crystalline compound of an element of sub-group IV of the Periodic Table, such as titanium, along with nitrogen or carbon. The crystallite-containing adhesive is applied to a substrate, such as a printed circuit module, in a compact adhesive layer of such thickness that the crystallites are exposed by pressing down on the electronic component. When the component, with its complementary contact surfaces positioned above the contact areas of the conductive traces, is pressed down onto the layer, the crystallites are pressed into contact with both the complementary contact surfaces and the conductive traces. At the same time, the adhesive holds the component securely on the circuit module. With such a structure, it is no longer necessary to remove the protective films or coatings from the contact areas of the traces or the complementary contact surfaces of the component inasmuch as the invention contemplates that the cover film, or films, are penetrated by the hard crystallites. In addition, if the contact areas or complementary surfaces have deteriorated due to the formation of an oxide layer or the like, the electrical connection is not harmed, since the hard crystallites penetrate through these layers as well. Furthermore, expensive platings of gold or other non-oxidizing metals in the region of the contact surfaces and/or the complementary contact surfaces are not necessary.

The crystallites are distributed within the adhesive so as to have little or no physical contact with one another, rendering the adhesive non-conductive in a direction parallel to the layer surface. The adhesive layer is non-conductive in the layer plane when the number of non-oxidizing crystallites in the adhesive layer is less than 10% by weight. The pressure to effect the connection is applied perpendicular to the adhesive layer, and therefore electrical contact is made perpendicular to the layer plane only, creating an anisotropic adhesive. In principle, a layer thickness of adhesive may be used which is thicker than the mean thickness of the individual crystallites. However, a preferred embodiment of the invention is characterized in that the compact layer has a thickness only slightly more than the thickness of a single crystallite.

In the preferred embodiment, the crystallites are composed of titanium nitride or titanium carbide. Such crystallites possess the sufficient conductivity and hardness contemplated by the invention.

The invention also discloses a process for making an electrical and a mechanical connection between the conductive traces of a printed circuit module and the complementary contact surfaces of an electronic component using the anisotropic adhesive.

Other objects, features and advantages of the invention will be apparent from the following detailed description, taken in connection with the accompanying drawings.

### Brief Description of the Drawings:

The invention is explained in detail below by means of the following drawings in which:
Fig. 1 is a plan view of a printed circuit module which includes electronic components mounted thereon;
Fig. 2 is a section taken along B-B of the article in Fig. 1, on an enlarged scale;
Fig. 3 is the section as in Fig. 2 at another process stage;
Fig. 4 is a section as in Figs. 2 and 3, at still a further process stage;
Fig. 5 is the portion C in Fig. 3 on a much enlarged scale; and
Fig. 6 is the portion D in Fig. 4 on the same scale as Fig. 5.

### Detailed Description of the Invention:

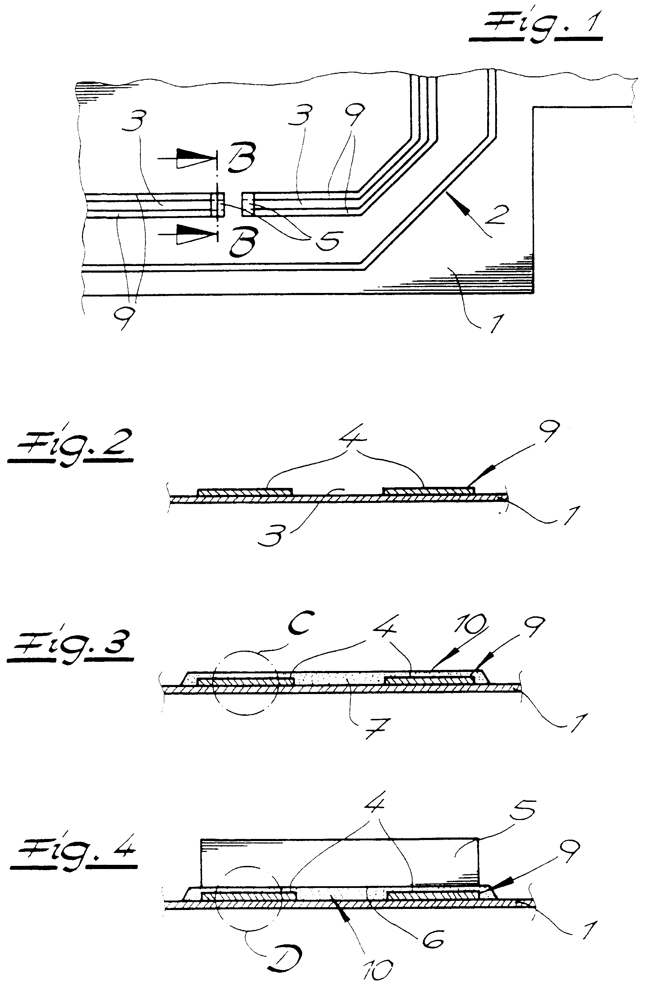

Figure 1 shows a printed circuit module 1 consisting of a flexible or rigid substrate. A printed ink layer 2 in the form of conductive traces 9 is printed thereon. The conductive traces 9 are separated from each other by intervening non-conductive spaces 3. Electronic components 5 are adapted to common the conductive traces 9, and two are shown connecting parallel conductive traces 9.

Figure 2 is a section of the circuit module, taken along line B-B in Figure 1, showing the two parallel printed conductive traces 9 of printed ink layer 2 at a first process stage. The conductive traces 9 are applied to printed circuit board module 1 by a screen printing process or the like, and include contact areas 4 for making an electrical connection to complementary contact surfaces of electronic component 5.

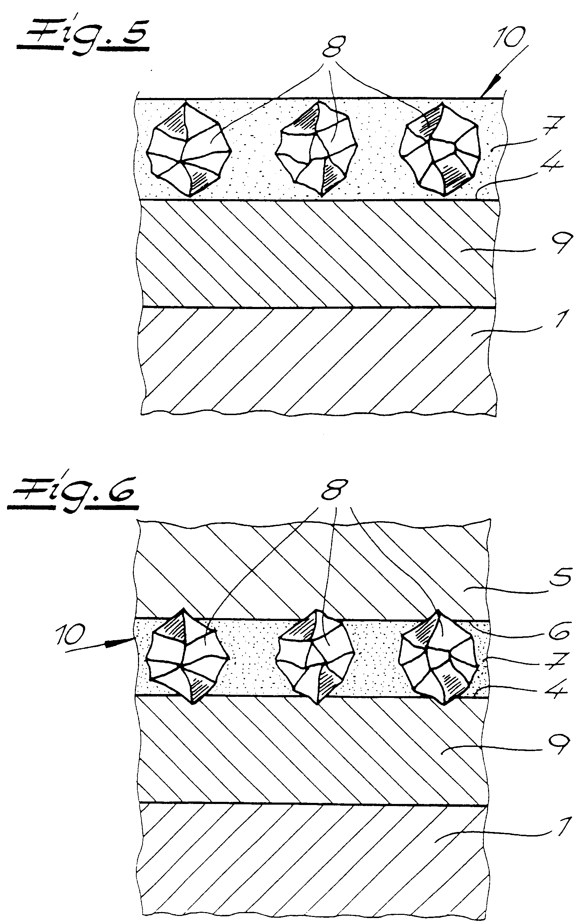

Figure 3 is a section of the circuit module, similar to that shown in Figure 2, but taken at a further process stage. An adhesive layer 10 is applied over the printed ink layer at least over contact areas 4 of the conductive traces 9, for example by screen printing. The non-conductive intervening space 3 between the conductive traces 9 in Figure 2 may also be provided with such adhesive layer 10. The adhesive layer comprises a known adhesive 7 having electrically conductive crystallites 8 embedded therein, described in further detail below.

Figure 4 is the section as shown in Figures 2 and 3 at a still further process stage, showing component 5, which includes complementary contact surfaces 6 for electrically connecting to contact areas 4, fixed to the circuit module with the aid of adhesive 7.

Figures 5 and 6 are enlarged depictions of portions C and D of Figures 3 and 4, respectively, showing the detail of adhesive layer 10. Adhesive 7 is a known plastic-based adhesive used in connecting electronic components to circuit modules and printed circuits. As can be seen in Figures 5 and 6, hard, non-oxidizing crystallites 8 are embedded in adhesive 7. The crystallites are formed of an electrically conductive crystalline compound of an element of sub-group IV of the Periodic Table, such as titanium, together with nitrogen or carbon. It can also be appreciated from these figures that crystallites 8 are distributed throughout the adhesive in such a way as to exhibit little or no physical contact with one another and therefore the adhesive possesses no conductivity along the layer plane. The adhesive layer is non-conductive in the layer plane when the number of non-oxidizing crystallites in the adhesive layer is less than 10% by weight. The adhesive layer 10 is applied so that crystallites 8 can be exposed by pressing down on electronic component 5. By comparing Figures 5 and 6, in conjunction with Figures 3 and 4, it can be seen that, after applying the compact adhesive layer 10, component 5 is pressed onto the adhesive layer 10, whereby crystallites 8 are pressed into contact areas 4 of conductive traces 9 and complementary contact surfaces 6 of electronic component 5 to effect an electrical connection therebetween, perpendicular to the adhesive layer plane. Inasmuch as the adhesive is only conductive in a direction perpendicular to the layer, the adhesive is anisotropic. It can also be suitable to proceed in the manner described if the contact area 4 and complementary contact surfaces 6 display a protective cover film or oxide layer, as the crystallites are sufficiently hard to penetrate through such layers.

Figure 5 shows how the crystallites 8 are arranged in the compact adhesive layer 10. Figure 6 shows how crystallites 8 have been pressed into both contact areas 4 of conductive traces 9 and complementary contact surfaces 6 of electronic component 5 to effect an electrical connection therebetween, perpendicular to the plane of the adhesive layer. In both figures, the crystallites have been exaggerated in size.

As shown in Figures 5, the preferred embodiment of the invention contemplates that the thickness of adhesive layer 10 be only slightly more than the thickness of a single crystallite 8. Crystallites 8 display relatively equal grain size within a very narrow range. In the preferred embodiment, crystallites 8 consist of titanium nitride or titanium carbide.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. In a printed circuit module assembly, including:
a printed circuit module (1) having conductive traces (9) with contact areas (4) positioned therealong adapted to make an electrical connection to complementary contact surfaces (6) of an electronic component (5); and
an adhesive layer (10) on the surface of the printed circuit module for connecting the contact surfaces of the electronic component to the contact areas of the conductive traces of the printed circuit module;
the improvement in said adhesive layer comprising:
electrically-conductivecrystallites (8) embedded therein consisting of a hard, non-oxidizing compound of an element of sub-group IV of the Periodic Table, and one of the elements selected from the group consisting of nitrogen and carbon,
whereby when the complementary contact surfaces of the electronic component are positioned over the contact areas of the conductive traces and pressure is applied, the crystallites effect an electrical connection therebetween.

2. In a printed circuit module assembly as set forth in claim 1 wherein the adhesive layer (10) has a thickness approximately slightly greater than the thickness of a single crystallite (8).

3. In a printed circuit module assembly as set forth in claim 2 wherein the crystallites (8) are distributed within the adhesive such that there is little or no physical contact therebetween.

4. In a printed circuit module assembly as set forth in claim 3 wherein the crystallites consist primarily of titanium nitride.

5. In a printed circuit module assembly as set forth in claim 3 wherein the crystallites consist primarily of titanium carbide.

6. In a printed circuit module assembly as set forth in claim 1 wherein the content of the crystallites in the adhesive layer is approximately 10% by weight.

7. A process for fixing an electronic component (5) to a printed circuit module using an adhesive (7):
wherein the printed circuit module includes a substrate (1) having conductive traces (9) printed thereon with contact areas (4) positioned therealong adapted to make electrical contact with a complementary contact (6) of an electronic component (5),
said process comprising the steps of:
1) embedding hard non-oxidizing crystallites (8) in the adhesive (7), the crystallites comprising an electrically-conductive crystalline compound of elements of sub-group IV of the Periodic Table, and one of the elements selected from the group consisting of nitrogen and carbon,
2) distributing the crystallites (8) in the adhesive (7) such that little or no physical contact between individual crystallites is effected;
3) applying the adhesive (7) to the printed circuit module in a compact adhesive layer (10); and
4) positioning the electronic component so that the complementary contact surfaces are overlying the contact areas of the conductive traces, and
5) pressing down on the electronic component (5);
whereby an electrical connection is effected between the complementary contact surfaces (6) of the component (5) and the contact areas (4) of the conductive traces.

8. The process as in Claim 7, wherein the compact adhesive layer (10) is applied in a thickness equal to slightly more than the thickness of a single crystallite (8).

9. The process as in Claim 7 wherein one of the contact areas (4) and complementary contact surfaces (6) includes a protective film, characterized in that by pressing on the component (5), the film is pierced by the crystallites (8).

10. The process as in Claim 7, wherein the compact adhesive layer (10) is applied by screen printing.

11. The process as in Claim 7, wherein the crystallites (8) are formed from titanium nitride.

12. The process as in Claim 1, wherein the crystallites (8) are formed from titanium carbide.
